(19) Europäisches Patentamt / European Patent Office / Office européen des brevets

(11) **EP 2 613 358 A2**

(12) **EUROPEAN PATENT APPLICATION**

(43) Date of publication:
**10.07.2013 Bulletin 2013/28**

(51) Int Cl.:
***H01L 31/0216*** $^{(2006.01)}$

(21) Application number: **13000006.0**

(22) Date of filing: **02.01.2013**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (71) Applicant: **OC Oerlikon Balzers AG**<br>**9496 Balzers (LI)** |
| (30) Priority: **04.01.2012 US 201261582880 P** | (72) Inventor: **Rattunde, Oliver**<br>**9470 Werdenberg (CH)** |

(54) **Double layer antireflection coating for silicon based solar cell modules**

(57) A silicon wafer-based solar cell with a two-layer antireflective coating (ARC) combines a 10-30nm thick hydrogen containing passivation layer (e.g. $Si_XN_Y$:H) with a top layer of $Nb_2O_5$ (or $Nb_XO_Y$ in general) for optimal matching the refractive index of the ARC to cover materials having a refractive index of about 1.5 (e.g. glass or EVA, Ethylene Vinyl Acetate). The two-layer ARC can be deposited either by PECVD or by reactive sputtering (PVD) of a Si target with $N_2$ and/or $NH_3$, and the $Nb_2O_5$ layer is deposited by reactive sputtering of either a pure Nb target or a conductive $Nb_2Ox$ (x<5) target with $O_2$.

Fig. 5

**Description**

This invention relates to an antireflective coating (ARC) on solar cells made of crystalline silicon as well as a method for producing such an antireflective coating. The aim of the invention is to describe an antireflective coating with optimized optical properties if the solar cell is encapsulated in a solar cell module (i.e. covered by glass or comparable polymer materials with refractive index of approx. 1.5). This ARC includes a hydrogenated silicon nitride ($Si_XN_Y$:H) layer for passivation as well as a niobium oxide ($Nb_2O_5$) layer with high refractive index but low absorption in the visible spectral range.

State of the art front-side ARC for crystalline solar cells exhibit a $Si_XN_Y$:H (short: SiN:H) layer with two functional properties: i) Reducing the amount of reflected light at the front-side of the solar cell device as well as ii) passivating the crystalline or multi-crystalline Si wafer material (field effect passivation & chemical passivation e.g. by hydrogen passivation of dangling bonds or impurities). These SiN:H films can be either deposited by PECVD or PVD techniques and usually have refractive indices at 633nm of 1.9-2.1 which gives optimal efficiencies (electrical power output /power input of incident useful light) for solar cells.

**SHORT DESCRIPTION OF THE FIGURES**

Fig.1: Calculated reflection (a) and solar module efficiency (b) for non-absorbing single ARC layers as a function of the refractive index of the ARC (constant refractive index - no dispersion).

Fig.2: Low wavelength absorption coefficient k (350nm) vs. refractive index n (633nm) for two SiN processes deposited by PVD (where SiN#1 is deposited using higher NH3 gas flow settings compared to SiN#2) together with PECVD data from reference "Doshi". All data originate from spectroscopic ellipsometry analysis of SiN:H single films on Si-wafers.

Fig.3: Calculated reflection & absorption (a) as well as resulting solar module efficiency (b) for non-absorbing single ARC layers compared to SiN:H with optical properties measured by spectroscopic ellipsometry from "real world" high refractive index SiN:H films deposited by PVD.

Fig.4: Calculated absorption (a), reflection & absorption (b) as well as resulting solar module efficiency (c) for single layer high refractive index SiN:H films, double layer SiN:H films (labeled "SiN_DL" and two SiN:H/ $Nb_2O_5$ double layer film stacks

Fig. 5 shows a basic embodiment of a layer sequence according to the invention.

**BACKGROUND OF THE INVENTION**

Generally, the optimum refractive index (n) of a single ARC film has to fulfill the well-known requirement

```
n = sqrt( n_s * n_m )                                    (Eq.1)
```

where n_s and n_m are the refractive indices of the substrate underneath and the medium above the ARC, respectively. Therefore optimal silicon solar cells (n_s=3.8 for Si; n_m=1.0 for air) require an ARC with n=1.95.

Solar cell modules on the other hand are covered by glass or plastic covers as well as polymer cements (e.g. EVA, Ethylene Vinyl Acetate) having a refractive index of around 1.5 at 633nm which requires an ARC with refractive index of 2.39 according to Eq.1.

The above mentioned requirements for cells and modules have been calculated for a single wavelength (in this case 633nm) for which the reflection of light is minimal. Nevertheless the above considerations are still valid if the solar cell efficiency is calculated by more elaborated methods including the optical properties of the ARC over the whole spectral range which is of importance for terrestrial solar applications. These more elaborated calculations can be performed either by dedicated software (e.g. PC-1D) or by calculating a weighted optical loss which reduces the efficiency of a hypothetical perfect ARC (transmission 100%). Every time simulated efficiencies are presented within the current work this second approach has been used, assuming an efficiency of 17.5% for a solar cell having perfect ARC.

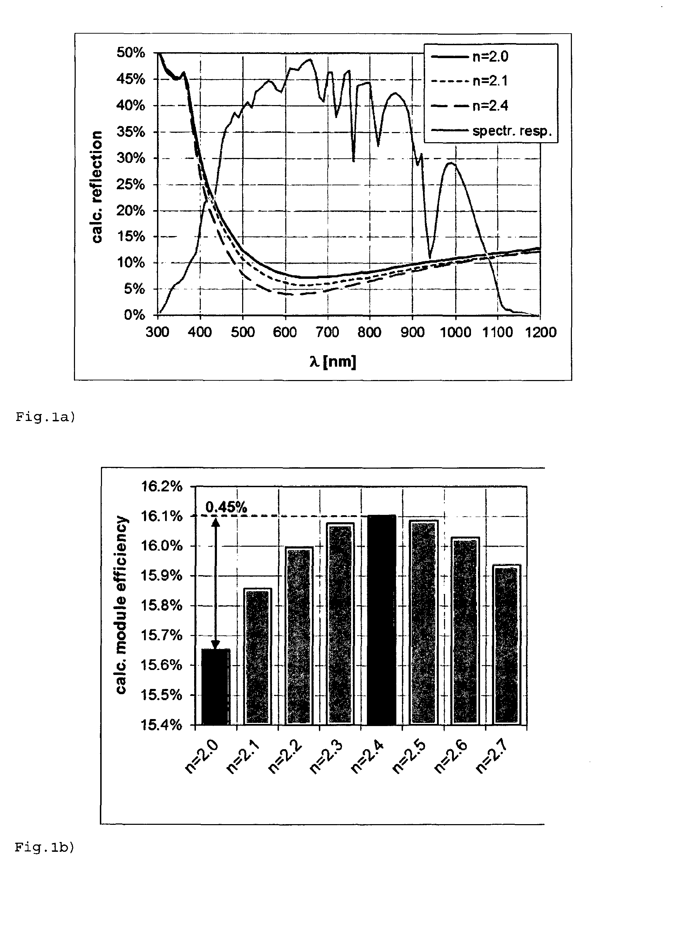

Fig.1 a) and b) show the results of such a simulation on module level: For each refractive index the optimal film thickness has been calculated, and the resulting module efficiencies show a significant improvement for a refractive index of 2.4 and film thickness of 64nm for the ARC. In order to calculate solar efficiency the reflection spectrum is convoluted by a spectral response function (also shown in the reflection graph) calculated from the AM1.5 photon flux multiplied by a typical IQE for mc-Si wafer material. Glass front-side reflection of 4% is also included in the reflection data.

(Note: If not stated otherwise all refractive indices stated from this point on refer to a wavelength of 633nm which is also roughly the weighted center of the AM1.5 solar spectrum.)

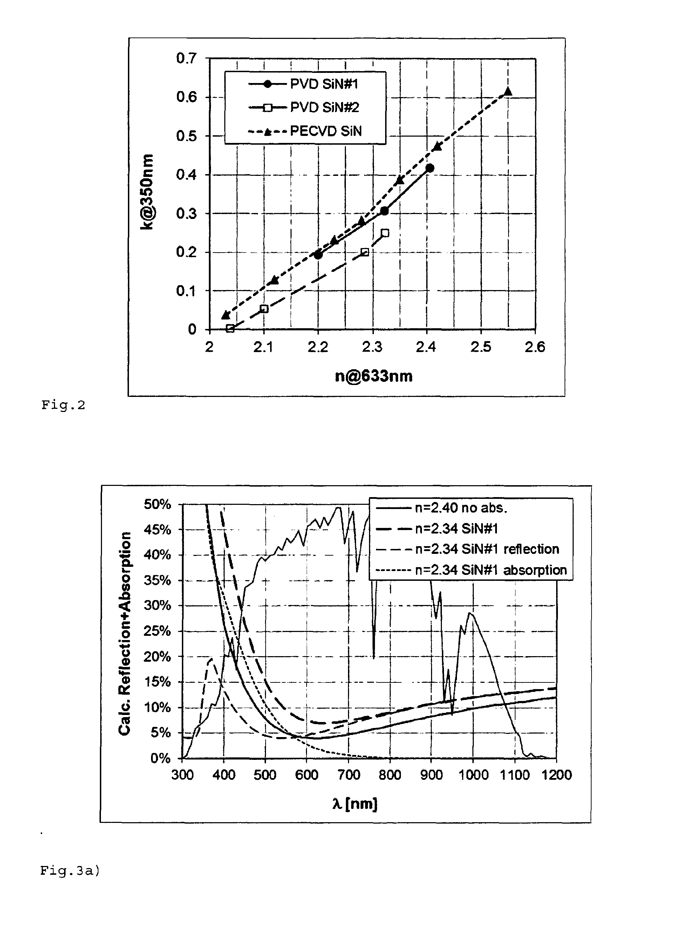

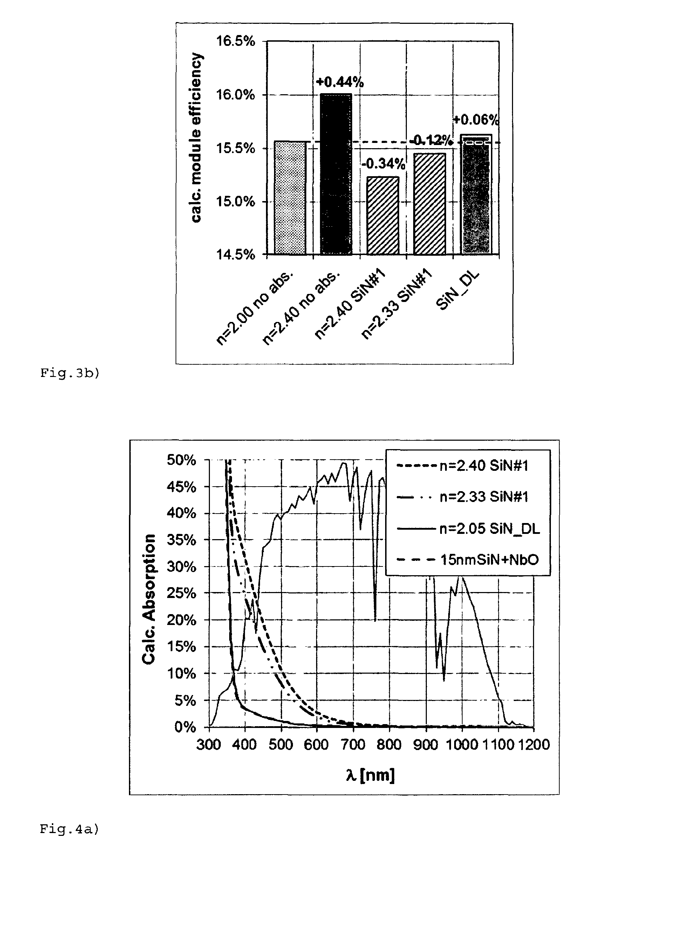

Eq.1 as well as the simulation results in Fig.1 are only valid if no absorption takes place in the spectral range from 300nm to 1200nm. This is no longer the case for Si-rich SiN:H films with high refractive indices. However, SiN:H deposited with PECVD or PVD methods only show minor absorption for refractive indices n<=2.0. Low wavelength absorption increases more or less linearly with the refractive index of the SiN:H layer (see Fig.2). For n>2.1 low wavelength absorption will jeopardize the positive effect of the higher refractive index and will result in significantly reduced solar module performance (see Fig.3).

The same trends have also been observed for PECVD SiN:H e.g. by Soppe et.al. [ Prog. Photovolt: Res. Appl. 2005; 13:551-569] or Doshi et.al. [ Applied Optics 36 (1997) 7826]: A compromise must be made in either the extinction coefficient or refractive index when trying to simultaneously obtain high values of n and low values of k in SiN:H films obtained from silane and ammonia.

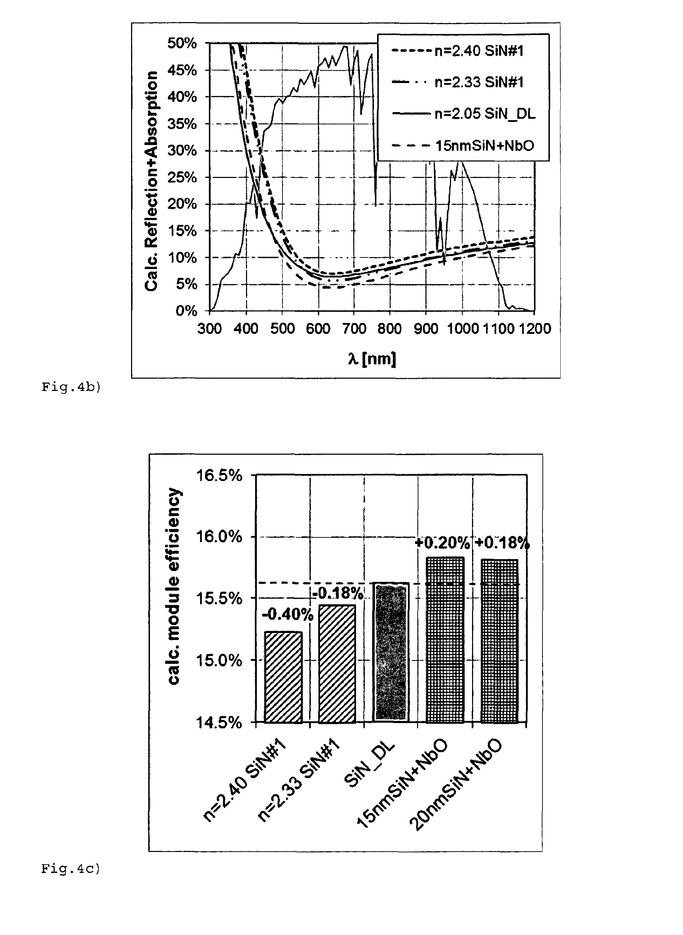

Results for PVD SiN:H ARCs as well as PECVD results published e.g. in Doshi et.al. or Moschner et al. [Prog. Photovolt: Res. Appl. 2004; 12:21-31] revealed that SiN:H layers show improved passivation if Si-rich films with a higher refractive index of 2.3-2.4 are used during the initial phase of the film growth (close to the Si-SiN interface). This led to the development of double- or gradient layers by means of altering reactive gas compositions during the SiN:H deposition in order to have high refractive index material only close to the interface and low index material (with low absorbance) during the main part of the film deposition. One typical example of such a double layer SiN:H (labeled "SiN_DL" in Fig. 3 and Fig.4) deposited by PVD with an overall refractive index of n=2.05 will act as a process of record for comparing it to improved layer stacks according to the present invention. For means of comparison the SiN_DL is also compared to the (hypothetical) non-absorbing layers in Fig.3.

Fig.3 shows the calculated reflection & absorption (a) as well as the resulting solar module efficiency (b) for non-absorbing single ARC layers compared to SiN:H with optical properties measured by spectroscopic ellipsometry from "real world" high refractive index SiN:H films deposited by PVD. Glass front-side reflection as well as low wavelength absorption of typical solar glass material has been considered in the calculation.

Several transparent materials (e.g. $TiO_x$ or $Nb_2O_5$) are known to have high refractive index n>2.2 and very low absorption from 300nm to 1200nm. But these materials will fall short in fulfilling the second requirement for solar cell ARCs: solar cell passivation by means of field effect passivation as well as chemical passivation e.g. by hydrogen passivation of dangling bonds or impurities.


## PRIOR ART

US 3,977,905 describes a single layer ARC made of $Nb_2O_5$ for use on solar cells protected by a glass cover, and specially emphasizes the low absorption in the short wavelength region from 300-500nm. In a preferred embodiment the niobium is deposited by standard electron beam evaporation. Since no hydrogen containing process gases are used this single layer $Nb_2O_5$ ARC is not able to create sufficient surface and bulk passivation which is needed for state of the art multi-crystalline or mono-crystalline Si solar cells.

On the other hand $Nb_2O_5$ is well known as low absorbing transparent film for all kinds of optical applications. $Nb_2O_5$ being part of a multilayer ARC is described e.g. in US 5,372,874 aiming at producing a broadband ARC for optical coatings with low absorption in the visible spectrum by means of reactive DC sputtering. The disclosure refers to a metal layer or specifically to a four layer ARC.

Two layer ARCs for solar cell applications are also published in numerous ways: E.g. GB1526171 describes a combination of a high refractive index material (n=2.35-2.4, preferably an oxide of titanium) together with a low refractive index material (n=1.6-1.7, preferably an oxide of aluminum) where the high refractive index material is closer to the Si wafer and the low index material closer to the glass cover.

A double layer with a designated passivation layer close to the substrate is described in WO/2007/051457. Here the second layer is designed in such a way to hinder out-diffusion of hydrogen into the ambient during furnace firing. For improved optical performance the first layer made of either 1-10nm of Si:H or 3-10nm of SiN:H is combined with a second layer of $TiO_2$, where the first layer is deposited by PECVD and the second $TiO_2$ layer is deposited by means of sputtering (PVD).

## SOLUTION ACCORDING TO THE INVENTION

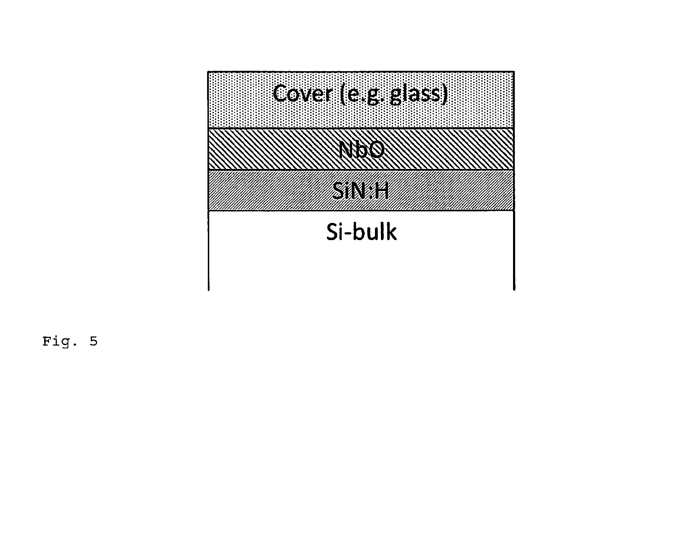

A sketch of the most basic embodiment of the invention is shown in Fig.5: On a wafer-based solar cell ("Si-bulk") a hydrogen containing passivation layer is arranged (SiN:H), followed by a Niobium-Oxide layer ("NbO"). Subsequently a cover (glass, EVA or alike) is being arranged on said NbO-layer.

The present invention proposes

1) Combining a 10-30nm thick hydrogen containing passivation layer (e.g. $Si_XN_Y$:H) with a top layer of $Nb_2O_5$ (or $Nb_XO_Y$ in general) for optimal matching the refractive index of the ARC to cover materials having a refractive index of about 1.5 (e.g. glass or EVA, Ethylene Vinyl Acetate).

A SiN:H film thickness of 10-30nm has been shown to offer sufficient passivation without too much degrading the optical properties by low-wavelength absorption. The resulting double layer ARC results in significantly enhanced solar module efficiency due to improved optical properties (see Fig.4).

2) The double layer according to 1) where the SiN:H layer is deposited either by PECVD or by reactive sputtering (PVD) of a Si target with $N_2$ and/or $NH_3$, and the $Nb_2O_5$ layer is deposited by reactive sputtering of either a pure Nb target or a conductive $Nb_2Ox$ (x<5) target with $O_2$.

Compared to $TiO_2$ the Niobium oxide reactive sputtering process is less dependent on the exact stoichiometry of the resulting film (especially when minimal low-wavelength absorption is mandatory), and also sputter rates for $Nb_2O_5$ are two to five times higher compared to $TiO_2$ (see e.g. [5]).

3) The double layer according to 1) and/or 2) where both layers are deposited in the very same single wafer multi chamber sputtering tool for optimized throughput and cost considerations.

4) The double layer according to 1) where the $Nb_2O_5$ layer is deposited in hydrogen containing gas atmosphere for improved hydrogen incorporation into the Si wafer as well as the Si/ARC interface after furnace firing.

5) The double layer according to 1) where the $Nb_2O_5$ is deposited only after the front and back contacts have been deposited (e.g. by screen printing) and contact has been established (e.g. by furnace firing of front- and backside paste). In this altered manufacturing sequence the front-contact does not need to penetrate through the $Nb_2O_5$ layer. In the case of screen printed front-side contact this altered manufacturing sequence may be an advantage for the optimizing of both, the chemical composition of the front-side paste as well as the parameters of the furnace firing process.

Fig.4a)-c) show Calculated absorption (a), reflection & absorption (b) as well as resulting solar module efficiency (c) for single layer high refractive index SiN:H films, double layer SiN:H films (labeled "SiN_DL", having a high refractive index of approx. n=2.3 close to the interface, and approx. n=2.0 for the second layer), and two SiN:H/ $Nb_2O_5$ double layer film stacks (with variable SiN film thickness but same overall thickness), respectively. Glass front-side reflection as well as low wavelength absorption of typical solar glass material is included in the calculation.

## Claims

1.   A silicon wafer-based solar cell with a two-layer antireflective coating comprising:

On a surface of a wafer-based silicon solar cell, said surface to be oriented to light during operation of said cell:

- A hydrogen containing silicon passivation layer followed by
- A niobium oxide $Nb_XO_Y$ layer
- A cover having a refractive index of about 1.5

2.   A solar cell according to claim 1, wherein the hydrogen containing silicon passivation layer is a hydrogenated silicon nitride $Si_XN_Y$:H layer.

3.   A solar cell according to claims 1 or 2, wherein the hydrogen containing silicon passivation layer has a thickness of 10-30nm.

4.   A solar cell according to claims 1-3, wherein the niobium oxide essentially comprises $Nb_2O_5$.

5.   A solar cell according to claims 1-4, wherein the cover comprises glass or Ethylene Vinyl Acetate.

6.   Method for manufacturing a silicon wafer-based solar cell with a two-layer antireflective coating, said method comprising:

Depositing a hydrogen containing silicon passivation layer on a surface of a wafer-based silicon solar cell, said surface to be oriented to light during operation of said cell;
followed by depositing a niobium oxide $Nb_XO_Y$ layer;
and attaching a cover having a refractive index of about 1.5 onto said niobium oxide layer.

7. The method according to claim 6, wherein the hydrogen containing silicon passivation layer is a hydrogenated silicon nitride $Si_XN_Y$:H layer.

8. The method according to claim 6 and/or 7, wherein the niobium oxide essentially comprises $Nb_2O_5$.

9. The method according to claim 7, wherein the $Si_XN_Y$:H layer is deposited either by PECVD or by reactive sputtering (PVD) from a Si target with $N_2$ and/or $NH_3$.

10. The method according to claim 6-9, wherein the $Nb_2O_5$ layer is deposited by reactive sputtering of either a pure Nb target or a conductive $Nb_2O_x$ (x<5) target with $O_2$.

11. The method according to claim 6-10, wherein both layers of the two-layer antireflective coating are deposited subsequently in one single wafer multi chamber sputtering tool.

12. The method according to claim 8-11, wherein the $Nb_2O_5$ layer is deposited in a hydrogen containing gas atmosphere.

Fig.1a)

Fig.1b)

Fig.2

Fig.3a)

Fig.3b)

Fig.4a)

Fig.4b)

Fig.4c)

Cover (e.g. glass)

NbO

SiN:H

Si-bulk

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3977905 A
- US 5372874 A
- GB 1526171 A
- WO 2007051457 A

**Non-patent literature cited in the description**

- **SOPPE.** *Prog. Photovolt: Res. Appl.,* 2005, vol. 13, 551-569
- **DOSHI.** *Applied Optics,* 1997, vol. 36, 7826
- **MOSCHNER et al.** *Prog. Photovolt: Res. Appl.,* 2004, vol. 12, 21-31